# EUROPEAN PATENT APPLICATION

(11) **EP 0 709 740 A1**
(43) Date of publication of application: **01.05.1996**
(21) Application number: 95115069.7
(22) Date of filing: 25.09.1995
(51) Int. Cl.: G03F 7/20, H01L 21/78

(54) **Integrated circuit and method of making the same**

(30) Priority: 30.09.1994 US 315640
(71) Applicant: TEXAS INSTRUMENTS INCORPORATED, Dallas Texas 75265 (US)
(72) Inventor: Bhuva, Rohit L., Plano, TX 75093 (US); Stubbs, Rex G., Jr., Sherman, TX 75092 (US)
(74) Representative: Schwepfinger, Karl-Heinz, Dipl.-Ing.

(57) **Abstract**

A method of fabricating dies (31,32,33) on a wafer (30), for integrated circuit devices (10). A single wafer (30) is used to fabricate dies (31,32, and 33) of different lengths. The dies (31,32, and 33) are arranged in a "stacked" pattern across the wafer (30), such that the dies are parallel with shorter dies (33) corresponding to shorter latitudes of the wafer (30) and longer dies (31) corresponding to longer latitudes of the wafer (30). Each die (31,32,33) has the same basic pattern of a left peripheral subcircuit, a repeating middle subcircuit, and a right subcircuit. The varying lengths of the dies (31,32,33) are accomplished by varying the number of repeating middle subcircuits.

## Description

### TECHNICAL FIELD OF THE INVENTION

This invention relates to integrated circuits, and more particularly, to fabricating integrated circuits having repeatable patterns.

### BACKGROUND OF THE INVENTION

One type of micro-mechanical spatial light modulator is a digital micro-mirror device (DMD), sometimes referred to as a deformable mirror device. The DMD has an array of hundreds or thousands of tiny tilting mirrors. Light incident on the DMD is selectively reflected or not reflected from each mirror to an image plane. To permit the mirrors to tilt, each is attached to one or more hinges mounted on support posts, and spaced by means of an air gap over underlying control circuitry. The control circuitry provides electrostatic forces, which cause each mirror to selectively tilt.

For electrophotographic applications, DMDs can be used instead of a modulated laser for exposing the photoreceptor drum. A DMD-based printer system uses a light source that is focused to the DMD array. The data signals that would have been used to modulate light from a laser, are used instead to control the individual mirrors of the DMD. The DMD is arranged in conjunction with optical components, such that in one deflection state, light reflected from each mirror has a reflection angle away from the photoreceptor drum. In another deflection state, the angle of light reflection changes, and the light is directed to the photoreceptor drum. From this point, the system functions in essentially the same manner as a conventional electrophotographic printer.

Typical DMD arrays for printing applications have at least as many mirror elements per row as required for a certain resolution and image size. For example, for a resolution of 600 dots per inch to be printed as an 11.7 inch image, the DMD must have a "length" of at least 600 x 11.7, or 7020, mirror elements per row.

In printer applications, the number of rows in the DMD array is related to various operational features, such as greyscale resolution or defect correction. Images are exposed one or more rows at a time, as the photoreceptor drum moves relative to the DMD. Typically, DMD arrays for printer applications are long and narrow, having a "width" that is relatively small compared to the number of pixels per row.

### SUMMARY OF THE INVENTION

One aspect of the invention is a method of fabricating dies for integrated circuits, which are fabricated by patterning at least one layer of materials deposited on a substrate and subsequently separating the wafer into dies. At least one layer for a first die is patterned on the wafer, such that said first die has at least one peripheral subcircuit and a repeating middle subcircuit. The patterning step is repeated for a number of dies on the same wafer. Each new die has one of at least two different lengths, with shorter dies being along shorter parallel latitudes of the wafer and longer dies being along longer parallel latitudes of the wafer.

In the case of the method as applied to the manufacture of DMDs, each die has a left peripheral subcircuit, a repeating middle subcircuit, and a right peripheral subcircuit. the peripheral subcircuits contain control circuitry such as row address lines and decoders. The middle subcircuit contains the array of mirror elements. The lengths of the dies are varied by varying the length of the rows of mirror elements.

An advantage of the invention is that a conventional silicon wafer is patterned to maximize the number of DMD dies on that wafer. As a result, die cost, and therefore product cost, are reduced.

### BRIEF DESCRIPTION OF THE DRAWINGS

Figures 1 and 2 illustrate a digital micro-mirror device (DMD), made in accordance with the invention.

Figure 3 illustrates a wafer upon which DMD dies are fabricated in accordance with the invention.

Figure 4 illustrates a "cut and repeat" reticle such as used to fabricate the wafer of Figure 3.

### DETAILED DESCRIPTION OF THE INVENTION

Although for purposes of example, the following description is in terms of fabricating a digital micro-mirror device (DMD), the invention is not limited to these devices. In general, the invention applies to fabrication of any integrated circuit that has repeatable subcircuits and whose die can be laid out with a long and narrow shape. Other examples of such devices are digital memories and liquid crystal devices (LCDs), each of which has an array of cells or pixels with a repeating design. Like DMDs, memories and LCDs have peripheral circuitry that can be laid out at the sides of the device.

In general, the term "DMD" is used herein to include any type of micro-mechanical device having at least one hinged and deflectable mass that is spaced by an air gap from a substrate, which it contacts in response to an applied force. The invention is used during fabrication of the DMD to maximize the use of the silicon wafers upon which the DMDs are fabricated.

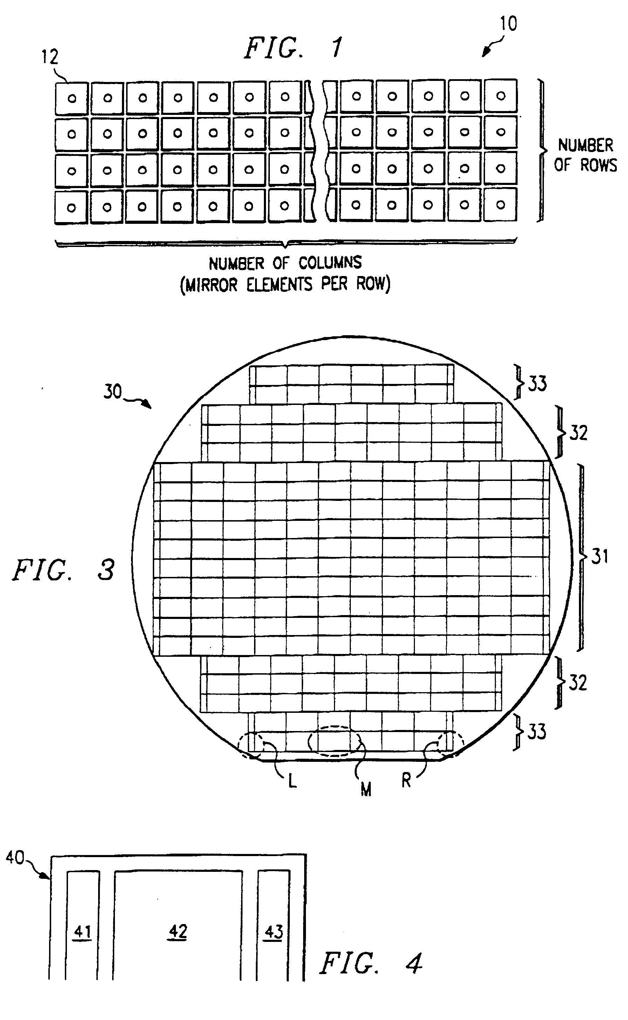

Figure 1 is a top plan view of a portion of a DMD 10 having an array of mirror elements 12. In the view of Figure 1, only the mirror 14 and mirror support post 16 of each mirror element 12 are shown. In a typical DMD 10, the mirror elements 12 are fabricated on 17 micron centers. As explained in the Background, DMDs for printer applications are typically elongated, with a relatively small number of rows as compared to the number of mirror elements 12 per row. In the example of this description, DMD 10 has 7056 columns (mirror elements per row) and 64 rows of mirror elements. This permits 64 rows of an image to be exposed at one time, with a maximum of 64 exposures per dot.

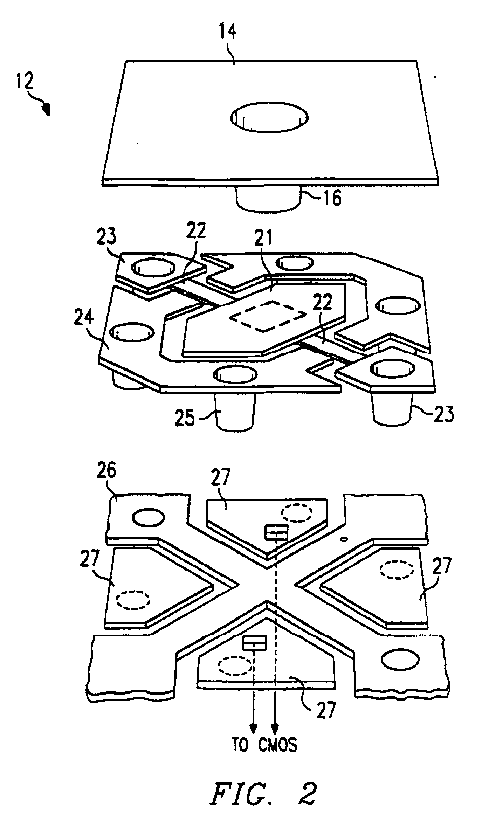

Figure 2 is an exploded perspective view of a single mirror element 12. For purposes of example, the DMD 10 is a hidden-hinge type DMD. As with other DMD designs, the hinges 22 are supported on support posts 23. Additionally, address electrodes 24 are supported by electrode posts 25 on the same level as hinges 22 and hinge support posts 23. The mirrors 14 are fabricated above the hinge/electrode layer and are supported by mirror support posts 16.

Mirror support post 16 is fabricated over a landing yoke 21. Landing yoke 21 is attached to one end of each of two torsion hinges 22. The other end of each torsion hinge 22 is attached to a hinge support post 23. Address electrodes 24 are supported by electrode support posts 25. The hinge support posts 23 and electrode support posts 25 support the hinges 22, address electrodes 24, and landing yoke 21 over a control bus 26 and address pads 27. When mirror 14 is tilted, the tip of the landing yoke 21 contacts the control bus 26. The control bus 26 and landing pads 27 have appropriate electrical contacts with a substrate of address and control circuitry, which is typically fabricated within the substrate using CMOS fabrication techniques.

Another type of DMD for which the invention could be useful is the torsion beam type, whose hinges are not hidden but rather extend from opposing sides of the mirror. Other types of DMDs are cantilever beam types and flexure beam types. Various DMD types are described in U.S. Patent No.4,662,746, entitled "Spatial Light Modulator and Method", U.S. Patent No. 4,956,610, entitled "Spatial Light Modulator"; U.S. Patent No. 5,061,049 entitled "Spatial Light Modulator and Method"; U.S. Patent No. 5,083,857 entitled "Multi-level Deformable Mirror Device"; and European Patent Application 94120234.3 (0664470), entitled "Improved Multi-Level Digital Micromirror Device". Each of these patents is assigned to Texas Instruments Incorporated and each is incorporated herein by reference.

In operation for printing applications, a light source illuminates the surface of the DMD 10. A lens system may be used to shape the light to approximately the size of the array of mirror elements 12 and to direct this light toward them. The mirror support post 16 permits mirror 14 to rotate under control of hinge 22. Mirror 14 rotates in response to an electrostatic force caused by application of an appropriate voltage to an address electrode 24. When mirror 14 rotates, yoke 21 contacts bus 26.

Voltages based on data in the memory cells of the underlying CMOS circuit are applied to the two address electrodes 24, which are located under opposing corners of mirror 14. Electrostatic forces between the mirrors 14 and their address electrodes 24 are produced by selective application of voltages to the address electrodes 24. The electrostatic force causes each mirror 14 to tilt either about +10 degrees (on) or about -10 degrees (off), thereby modulating the light incident on the surface of the DMD. Light reflected from the "on" mirrors 14 is directed to the photoreceptor drum. Light from the "off" mirrors 14 is reflected away from the drum. The resulting pattern forms an image. Various greyscale techniques can be used as described in U.S. Patent Serial No. 08/038,398 (Atty Dkt. No. TI-17632), entitled "Process and Architecture for Digital Micromirror Printer", assigned to Texas Instruments Incorporated and, and incorporated by reference herein.

In effect, the mirror 14 and its address electrodes 24 form capacitors. When appropriate voltages are applied to a mirror 14 and its address electrodes 24, a resulting electrostatic force (attracting or repelling) causes the mirror 14 to tilt toward the attracting address electrode 24 or away from the repelling address electrode 24. The mirror 14 tilts until yoke 21 contacts bus 26.

Once the electrostatic force between the address electrodes 24 and the mirror 14 is removed, the energy stored in the hinge 22 provides a restoring force to return the mirror 14 to an undeflected position. Appropriate voltages may be applied to the mirror 14 or address electrodes 24 to aid in returning the mirror 14 to its undeflected position.

Figure 3 illustrates a method aspect of the invention, which is a method of fabricating DMD dies on a wafer. Figure 3 is a top plan view of a wafer 30 that has been fabricated into dies ready to be cut into chips. The wafer 30 has been fabricated as a number of layers that correspond to the layers of the DMD 10 illustrated in Figures 1 and 2. This fabrication is accomplished by patterning each layer, one layer at a time, upward from the substrate. By "patterning" is meant various photolithography steps, including exposure and etching, conventionally used for fabricating integrated circuits on a substrate. As discussed below in connection with Figure 4, a reticle is typically used during the exposure step.

In the example of this description, the dies on wafer 30 are for a "hidden-hinge" type DMD. The "multi-level" DMD patent and patent application cited above describe these patterning steps. A typical hidden-hinge fabrication process involves patterning a number of different layers.
Wafer 30 is a conventional 6" circumference wafer. Its dies are arranged in strips across the diameter of wafer 30. The dies may have one of a number of lengths, with the different lengths being for different DMD array sizes. In the example of this description,
wafer 30 is patterned with three different sizes of dies, each die size representing a different DMD array size.

A first set of DMD dies 31 has a size of 4.9" by 0.2" which is appropriate for an 11.7 inch image with 600 dots per inch. A set of these dies 31 is arranged across the mid-band of wafer 30. These dies 31 are referred to herein as the "full-length" dies. In the example of this description, there are twelve dies 31.

A second set of DMD dies 32 has a size of 3.7" by 0.2", which is appropriate for an 8.5" image with 600 dots per inch. These dies 32 are arranged across wafer 30 between the full-length dies 31 and the edge of wafer 30. These dies 32 are referred to herein as the "mid-length" dies. In the example of this description, there are eight dies 32, four on either side of dies 31.

A third set of DMD dies 33 has a size of 2.58" by 0.2", which is appropriate for an 11.7" image with 300 dots per inch. These dies 33 are arranged across wafer 30, between the mid-length dies 32 and the edge of wafer 30. In the example of this description, there are four of these dies 33, two on either side of dies 32. These dies 33 are referred to herein as the "short-length" dies 33.

Each size of die 31, 32, and 33 has the same orientation on wafer 30. In other words, the rows of mirror elements 12 of all dies are parallel.

Thus, dies 31, 32, and 33 are "stacked" outwardly from the diameter of wafer 30, such that as the parallel latitude of wafer 30 decreases, the dies are shorter. Although in the example of this description, wafer 30 has three different sizes of dies, the same concepts could be used with only two different sizes or with more than three different sizes. The common feature would be the "stacking" of dies to correspond to the varying parallel latitude of wafer 30.

A feature of the invention is that all dies 31, 32, and 33 have the same types of subcircuits. Each has a left subcircuit, L, which includes circuitry that is peripheral to the mirror elements 12, such as control circuitry. Each also has a number of repeating middle subcircuits, M, which include a number of mirror elements. Although each has a different number of these middle subcircuits, M, each M component is the same. Repeating subcircuits, M, are contiguous in each die, have equal size in all dies, and are internally identical in all dies. Each also has a right subcircuit, R, which like the left subcircuit, L, includes peripheral circuitry. Other than their number of middle subcircuits, M, dies 31, 32, and 33 are the same. In other words, each die has the same basic pattern, with a repeating subcircuit being used to vary the length of each die.

Figure 4 illustrates a "cut and repeat" reticle 40, such as may be used to pattern dies 31, 32, and 33, in accordance with the present invention. Reticle 40 has three masks, 41, 42, and 43, which correspond to the three types of subcircuits, L, M, and R, of dies 31, 32, and 33. As in conventional reticles, reticle 40 is patterned on a transparent material such as glass. The patterning of each mask 41, 42, and 43 is accomplished by conventional methods, resulting in each mask having its own unique pattern of opaque and transparent features, which either block or transmit light so as to transfer the same pattern to the surface of a wafer.

A left mask 41 contains the pattern for the left peripheral subcircuit, L. A repeatable mask 42 contains the pattern of each repeatable subcircuit, M. A right mask 43 contains the pattern for the right peripheral subcircuit, R. The peripheral subcircuit may comprise row address and other control circuitry.

Further details on the use of "cut and repeat" reticles are set out in European Patent Application 93120290.7 (Atty Dkt. No. TI-17332), entitled " Large Die Photolithography", assigned to Texas Instruments Incorporated and Incorporated herein by reference.

In operation, reticle 40 is used to expose all areas of a layer on wafer 30. For each die, reticle 40 is first placed at an initial position to expose the left peripheral subcircuit L with the left mask 41. At this time, only the left mask 41 transmits light to expose the surface of wafer 30; masks 42 and 43 are shuttered off or otherwise blocked so that they do not transmit light.

Then, reticle 40 is stepped, relative to the surface of wafer 30, an appropriate distance to the right, and blocked so that only mask 42 transmits light to wafer 30. Reticle 40 is illuminated and stepped a number of times to expose a first repeatable subcircuit M, then a second repeatable circuit M, etc., for as many times as required to expose an entire array of repeatable subcircuits M on wafer 30. Finally, the reticle 40 is stepped into position to expose the right peripheral subcircuit R with the right mask 43. The stepping of the above process differs from that of conventional step and repeat processes in that each stepping movement is in accordance with the mask size rather than the reticle size. Also, there is no need to remove reticle 40 when the pattern changes.

The above description is in the terms of a single die, i.e., a portion of wafer 30 that will result in a single integrated circuit device. The same process is repeated for each die on the wafer 30. Also, for dies having multiple layers, the process is repeated, for each layer, typically with a different reticle for each layer.

### Other Embodiments

Although the invention has been described with reference to specific embodiments, this description is not meant to be construed in a limiting sense. Various modifications of the disclosed embodiments, as well as alternative embodiments, will be apparent to persons skilled in the art. It is, therefore, contemplated that the appended claims will cover all modifications that fall within the true scope of the invention.

## Claims

1. A method of fabricating dies for integrated circuits, which are fabricated by patterning at least one layer of materials deposited on a substrate and subsequently separating the wafer into dies, comprising the steps of:
patterning, said at least one layer on said wafer, for a first die, such that said first die has at least one peripheral subcircuit and a repeating middle subcircuit; and
repeating said patterning step for a number of dies on said wafer, each die being of one of at least two different lengths, with shorter dies being along shorter parallel latitudes of said wafer and longer dies being along longer parallel latitudes of said wafer.

2. The method of Claim 1, further comprising providing each die having a left peripheral subcircuit and a right peripheral subcircuit.

3. The method of Claim 1 or Claim 2, further comprising providing said integrated circuit as a digital memory, and said repeating middle subcircuit as an array of memory cells.

4. The method of Claim 1 or Claim 2, further comprising forming said integrated circuit as a digital micro-mirror device, and said repeating middle subcircuit as an array of mirror elements.

5. The method of any preceding claim, wherein said patterning step comprising patterning with a single reticle for each layer of said wafer, said reticle having a mask corresponding to a layer of each subcircuit of said wafer.

6. The method of any preceding claim, further comprising varying the lengths by varying the number of said middle subcircuits.

7. An improved wafer having dies for a device, each die representing an elongated array of elements and at least one peripheral subcircuit, wherein said improvement comprises:
an arrangement of said dies, such that said wafer has a number of dies, each die having one of at least two varying lengths, in parallel across said wafer, with shorter dies being along shorter parallel latitudes of said wafer and longer dies being along longer parallel latitudes of said wafer, and such that each said die has the same basic pattern of a left peripheral subcircuit, a series of repeating middle subcircuits comprised of mirror elements, and a right peripheral subcircuit.

8. The wafer of Claim 7, wherein the device is a digital micromirror for printer applications and the elements are mirror elements.

9. The wafer of Claim 7 or Claim 8, wherein said wafer has dies of two or more different lengths, with a number of dies of each length.

10. The wafer of Claim 9, wherein said different lengths correspond to varying numbers of said repeating middle subcircuits.
